(19) Europäisches Patentamt
European Patent Office
Office européen des brevets

(11) **EP 2 239 784 A2**

(12) **EUROPÄISCHE PATENTANMELDUNG**

(43) Veröffentlichungstag:
**13.10.2010 Patentblatt 2010/41**

(51) Int Cl.:
***H01L 31/048*** *(2006.01)*

(21) Anmeldenummer: **10157324.4**

(22) Anmeldetag: **23.03.2010**

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**
Benannte Erstreckungsstaaten:
**AL BA ME RS**

(30) Priorität: **09.04.2009 DE 102009016735**

(71) Anmelder: **Schott AG**
**55122 Mainz (DE)**

(72) Erfinder:
• **Nattermann, Kurt**
  **55347, Ockenheim (DE)**

• **Schwirtlich, Ingo**
  **63897, Miltenberg (DE)**
• **Fliedener, Uwe**
  **63801, Kleinostheim (DE)**
• **Engelmann, Harry**
  **55218, Ingelheim (DE)**

(74) Vertreter: **Hrovat, Andrea Darinka**
**FUCHS Patentanwälte**
**Westhafenplatz 1**
**60327 Frankfurt am Main (DE)**

(54) **Photovoltaikmodule mit reduziertem Gewicht**

(57)    Es werden Solarmodule beschrieben, die aufgrund der besonderen Beschaffenheit ihrer Front- und Rückscheiben eine hohe Stabilität bei geringem Gewicht aufweisen.

Das erfindungsgemäße Konstruktionsprinzip ermöglicht es, große, plattenförmige Solarmodule mit geringem Gewicht bereit zu stellen, die eine hohe mechanische Belastbarkeit aufweisen, unempfindlich gegenüber rauen klimatischen Umwelteinflüssen sind und den thermischen Belastungen durch Sonneneinstrahlungen und Abschattung widerstehen.

**Abb. 3**

## Beschreibung

### Einleitung

Die vorliegende Erfindung betrifft Solarmodule, die aufgrund der besonderen Beschaffenheit ihrer Front- und Rückscheiben eine hohe Stabilität bei geringem Gewicht aufweisen. Bevorzugte Scheiben sind Glasscheiben und im Folgenden beinhaltet der Begriff "Scheibe" auch eine Glasscheibe.

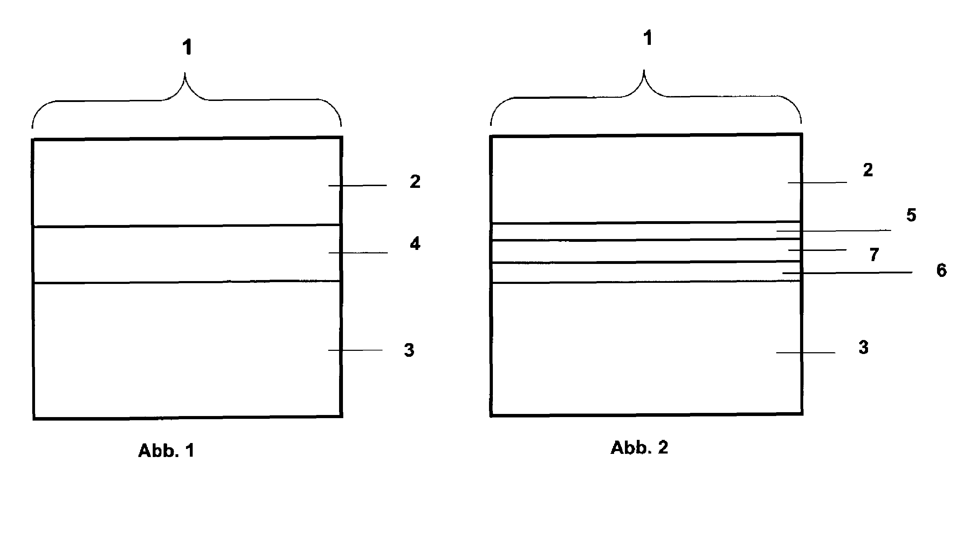

Solarmodule haben üblicherweise einen Aufbau gemäß Abbildung 1. Demnach umfassen Solarmodule üblicherweise eine Frontscheibe 2, eine Rückscheibe 3 und eine Zwischenschicht 4. Die Zwischenschicht setzt sich wie in Abbildung 2 gezeigt meist aus Einbettungsmaterialschichten 5 und 6 sowie den Solarzellen 7 zusammen. Die Einbettungsmaterialschichten 5 und 6 können selbst Laminate sein, also aus mehreren Einzelschichten bestehen.

Die erfindungsgemäßen Solarmodule weisen grundsätzlich einen ähnlichen Aufbau auf. Sie zeichnen sich aber durch besondere Beschaffenheit der Frontscheibe und der Rückscheibe aus.

Durch die besondere Beschaffenheit der Frontscheibe und der Rückscheibe gemäß der vorliegenden Erfindung werden Solarmodule bereitgestellt, die eine verbesserte Stabilität bei verringertem Gewicht im Vergleich zu Solarmodulen des Standes der Technik aufweisen. Auf diese Weise ist es möglich, größere Module bereitzustellen, die dennoch ein handhabbares Gewicht aufweisen.

Solarzellen zur direkten Umwandlung von Sonnenenergie in elektrischen Strom müssen zum mechanischen Schutz z.B. vor Hagel, Beschädigungen bei der Montage oder Wartung und korrosiven Umgebungseinflüssen sowie zur Erzielung der erforderlichen elektrischen Sicherheit eingekapselt werden. Die wesentlichen Komponenten der Einkapselung sind eine optisch transparente Frontscheibe, Einbettungsmaterialien, in denen die Solarzellen einlaminiert oder eingegossen sind und die zumindest zwischen der Frontscheibe und den Solarzellen transparent sind, und eine Rückseitenfolie auf der Solarmodulrückseite. Der Verbund aus Frontscheibe, Einbettungsmaterialien, Solarzellen, integrierten Komponenten, Rückseitenfolie und Rückscheibe sowie ggf. einem Rahmen wird als Solarmodul bezeichnet.

Frontscheiben bestehen üblicherweise aus Natronsilicatgläsern mit einer Dicke von mehr als 3 mm, damit diese thermisch vorgespannt werden können. In gewalzten Frontscheiben kann man auf der Außenseite Oberflächenstrukturen einwalzen oder prägen, um eine gerichtete Reflexion von Licht zu verhindern oder die Einkopplungseffizienz für die Sonnenstrahlung zu erhöhen. Es ist möglich, die Außenfläche zur Verbesserung der Strahlungseinkopplung zu beschichten.

Als Einbettungsmaterialien eignen sich Polymermaterialien wie z.B. EVA (Ethylen-Vinyl-Acetat), das relativ preiswert ist und gut bekannte Eigenschaften aufweist. Die Einbettungsmaterialien werden üblicherweise in Form von Folien mit Dicken zwischen 0,4 bis 0,8 mm verwendet.

Bei den Solarzellen kann es sich um Scheiben aus polykristallinem Silizium mit Dicken zwischen 0,1 und 0,4 mm handeln. Man kann Solarzellen auch direkt auf die Frontscheibe aufbringen; dies geschieht in der Regel mit einer transparenten und elektrisch leitenden Zwischenschicht. Bei einigen Ausführungsformen von Dünnschichtmodulen sind Solarzellen auf separaten Trägerscheiben z.B. aus elektrisch leitenden Blechen im Modul eingebettet. In der mechanischen Auslegung der Solarmodule ersetzt dann die Trägerscheibe mit den Solarzellen die eigentlichen Solarzellen.

Es sind viele Rückseitenfolien bekannt, wie beispielsweise TPT® (Tedlar-PET-Tedlar, Tedlar = Polyvinylfluorid) und TAP®-Laminate (Tedlar-Aluminium-PET) mit typischen Dicken von 0,3 bis 0,8 mm. Für die Rückseite können auch Metallplatten oder Glasscheiben verwendet werden. Letztere werden als Doppelglasmodule bezeichnet. Dafür werden auch Kalknatronsilicatgläser verwendet, die Dicken von in der Regel mehr als 3 mm aufweisen, damit diese thermisch vorgespannt werden können. Normalerweise sind Doppelglasmodule symmetrisch aufgebaut, d.h. Front- und Rückscheibe sind etwa gleich dick.

Von der Front- oder Rückscheibe hat wenigstens eine eine Tragfunktion; bei Doppelglasmodulen sind es beide Scheiben. Dabei nehmen beide Scheiben die Lasten auf, die durch Eigengewicht, Wind-, Eis- und Schneelasten entstehen, und leiten diese über den Rahmen, Klammern an den Kanten oder ähnliches an die Unterkonstruktion der Solarmodule weiter.

Solarmodule für terrestrische Anwendung müssen für den Temperaturbereich von - 40 bis 85°C ausgelegt werden. Da Solarmodule üblicherweise durch Laminieren bei Temperaturen von bis zu 150°C gefügt werden, beträgt der Temperaturbereich, den ein Solarmodul "überleben" muss sogar - 40 bis 150°C. Die Belastung entsteht dabei durch unterschiedliche thermische Ausdehnungskoeffizienten $\alpha$ von Modulkomponenten. Als Richtwerte kann von folgenden Werten ausgegangen werden:

- für die für Front- und Rückscheiben üblicherweise verwendeten Natronsilicatgläser findet man $\alpha$-Werte im Bereich von $8 * 10^{-6}$ bis $10 * 10^{-6}$ $K^{-1}$.
- für Rückseitenfolien aus Polymermaterialien (z.B. TPT®) findet man Werte im Bereich von $50 * 10^{-6}$ bis $150 * 10^{-6}$ $K^{-1}$, wobei dieser Wert stark nichtlinear von der Temperatur abhängt und sich im Laufe der Zeit ändern kann.
- bei Rückseitenfolien aus Polymer-Metall-Verbunden (z.B. TAP®) prägt die Metallschicht aufgrund ihres relativ hohen Elastizitätsmoduls den Ausdehnungskoeffizienten für den gesamten Verbund. Bei TAP® findet man etwa $\alpha = 13 * 10^{6-}$ K$^{-1}$ bis $18 * 10^{-6}$ K$^{-1}$.

- für Einbettungsmaterialien aus Polymeren findet man Werte im Bereich von $50 * 10^{-6}$ bis $200 * 10^{-6}$ K$^{-1}$, wobei der Wert nicht linear von der Temperatur abhängt und sich im Laufe der Zeit verändern kann.
- für die Schicht mit den Solarzellen, z.B. aus kristallinen Si-Scheiben findet man einen mittleren Ausdehnungskoeffizienten von etwa $4 * 10^{-6}$ K$^{-1}$.
- für Dünnschichtmodule, bei denen die Zellen direkt auf die Front- oder Rückscheibe aufgebracht sind, wird die thermische Ausdehnung der Zellen vernachlässigt. Falls die Zellen auf separaten Trägerscheiben aufgebracht sind, wird der mittlere Ausdehnungskoeffizient der Trägerscheiben berücksichtigt. Unter "mittlerem Ausdehnungskoeffizienten" wird dabei der Ausdehnungskoeffizient verstanden, der sich ergibt, wenn man die Ausdehnungskoeffizienten der Materialien in der Solarmodulebene unter Berücksichtigung ihrer relativen Längenanteile mittelt.

Durch unterschiedliche Ausdehnungskoeffizienten der Solarmodulkomponenten können bei Temperaturwechseln mechanische Spannungen in den Solarmodulen entstehen und die Solarmodule verformen. Eine starke Verformung kann z.B. zu hohen mechanischen Belastungen in Montageelementen und in Dachkonstruktionen führen.

## Stand der Technik

In der Vergangenheit sind viele Versuche unternommen worden, die Stabilität von Solarmodulen bei reduziertem Gewicht zu erhalten. EP 1 798 775 A2 z.B. beschreibt Solarmodule, bei denen die Front- und/oder die Rückscheibe aus Borosilicatglas besteht. Übliche Borosilicatgläser haben im relevanten Temperaturbereich thermische Ausdehnungskoeffizienten von 3,3 bis $6 * 10^{-6}$ K$^{-1}$ und sind damit besser an den Ausdehnungskoeffizienten der Siliziumsolarzellen (ca. $2,6 * 10^{-6}$ K$^{-1}$) angepasst als Natronsilicatgläser. Dies kann thermomechanische Spannungen in den Solarmodulen reduzieren, verringert aber nicht das Gewicht der Solarmodule.
Bei den Doppelglasmodulen ist bekannt, thermomechanische Belastungen durch einen symmetrischen Aufbau zu reduzieren: Front- und Rückscheibe bestehen aus dem gleichen Glas (gleicher Ausdehnungskoeffizient) und sind annähernd gleich dick. Das verhindert den "Bi-Metall-Effekt" bei Temperaturänderungen mit einer starken Verwölbung der Scheiben, die zu hohen Biegespannungen in den Modulkomponenten oder zu hohen mechanischen Lasten in den Montageelementen oder Dachkonstruktionen führen.
Bei Folienrückseitenmodulen kompensiert man thermomechanische Belastungen in der Regel durch Nutzung einer den Einbettungsmaterialien und der Rückseitenfolie inhärenten viskoelastischen oder viskoplastischen Kriechfähigkeit. Falls die Temperaturänderungen nicht zu schnell erfolgen, relaxieren die mechanischen Spannungen in den Einbettungsmaterialien und Folien "weg", so dass thermisches Dehnen und Schrumpfen dieser Materialien nur geringe mechanische Spannungen erzeugt.
Bei Folienrückseitenmodulen mit Metallzwischenlagen in den Rückseitenfolien (z.B. TAP®) sind die Metalllagen in der Regel so dünn, dass sie bei thermomechanischen Dehnungen keine nennenswerten Kräfte auf das Solarmodul ausüben. Bei starken Temperaturänderungen können Rückseitenfolien bei hoher Kriechfähigkeit der unter der Folie liegenden Einbettungsmaterialien Wellen ausbilden. Diese sind aber in der Regel mit keinen nennenswerten mechanischen Belastungen der Solarmodule verbunden.
Typische Abmessungen von Solarmodulen sind $1,1 * 1,3$ m$^2$. Bevorzugt werden größere Module, weil das Herstellungskosten, Aufwand für Lagerung, Transportkosten, notwendige Montageelemente und notwendige elektrische Beschaltung senkt. In der Entwicklung sind bereits Module mit Abmessungen von $2,2 * 2,6$ m$^2$. Große Module, deren Gewicht nicht reduziert wurde, führen zu folgenden Problemen:

- Die Handhabung großer Module ist wegen ihrer Sperrigkeit und des hohen Gewichtes umständlich. Solarmodule werden überwiegend manuell installiert. Da die Sperrigkeit durch die Masse der Solarmodule vorgegeben ist, entsteht der Wunsch nach einer Gewichtsreduzierung, sodass auch große Module von einer bis zwei Personen getragen werden können.
- Ein hohes Gewicht von Einzelmodulen stellt erhöhte Anforderungen an die Montageelemente und Dachkonstruktionen.
- Große Module werden durch ihr Eigengewicht stärker belastet.
- Große Module sind durch Wind-, Hagel- und Schneelasten stärker belastet.

Durch Wind- und Schneelasten werden die Solarmodule elastisch oder plastisch verbogen oder es entstehen mechanische Spannungen in Modulkomponenten insbesondere in den Flächen, Kanten und ggf. Durchführungen in den Front- und Rückscheiben.
Im günstigsten Fall verhält sich ein Solarmodul elastisch oder viskoelastisch. Um die durch Wind, Schnee und Eigengewicht erzeugte Durchbiegung eines Solarmoduls abzuschätzen, kann das Modul näherungsweise als Kirchhoffsche Platte angesehen werden. Für eine Kirchhoffsche Platte, die durch homogenen Druck auf der gesamten Fläche belastet wird (Prüfbedingung nach Norm EN 61215), skaliert die Durchbiegung gemäß

$$w \propto {L^4}/{t^3}$$

Hierbei bezeichnet w die Pfeilhöhe der Durchbiegung (z.B. den Abstand der höchsten Stelle auf der Frontscheiben-Oberseite zur tiefsten Stelle), L eine repräsentative Kantenlänge des Solarmoduls oder seine Diagonale oder den Durchmesser bei runden Modulen und t die Dicke des Moduls. Beschränkt man die maximale Durchbiegung der Module, so skaliert die erforderliche Dicke $t_{erf}$ und das Gewicht des Solarmoduls G wie folgt mit der Modulgröße:

$$t_{erf} \propto L^{1,33}$$

$$G \propto L^{3,33}$$

D.h. die erforderliche Dicke eines Solarmoduls und sein Gewicht wachsen überproportional mit seinen Querabmessungen. Dazu eine Abschätzung: Kommt man bei einem 1,1 x 1,3 m$^2$ großen Solarmodul noch mit einer 3 mm dicken Glasscheibe für die Frontscheibe aus, so wären bei dem 2,2 x 2,6 m$^2$ großen Modul mindestens 7,5 mm erforderlich, um seine Durchbiegung zu beschränken. Das Gewicht des Moduls würde sich dadurch verzehnfachen. So schwere Module lassen sich kaum handhaben.

Die Offenlegungsschrift DE 10 2005 057 468 A1 beschreibt ein Solarmodul, das zur Versteifung auf eine durch Stützrahmen verstärkte Leichtbaustruktur geklebt ist. Dieser Vorschlag hat mehrere Nachteile: Bei Temperaturänderungen entstehen in den Verklebungszonen zwischen den Solarmodulen und der Leichtbaustruktur hohe Scher- und Normalspannungen, die auf Dauer zum Versagen des Verbundes führen können. Die Leichtbaustruktur ist dick und schwer. Sie erfordert außerdem spezielle Unterkonstruktionen.

Die Offenlegungsschrift DE 10 2005 030 039 A1 beschreibt eine Unterkonstruktion für die Befestigung von Solarmodulen auf Flachdächern, bei der durch Windleitbleche und Windabweiser die Belastung der Dächer durch Windlasten auf den Modulen vermindert wird. Das behebt aber nicht das Problem der Schneelasten. Außerdem bleibt noch die Aufgabe, großflächige Solarmodule zu schaffen, die den Windlasten standhalten.

Es besteht ein hoher Bedarf an großen Solarmodulen mit geringem Gewicht.

**Aufgabe**

Es ist die Aufgabe der vorliegenden Erfindung, große, plattenförmige Solarmodule mit geringem Gewicht bereit zu stellen, die eine hohe mechanische Belastbarkeit aufweisen, unempfindlich gegenüber rauen klimatischen Umwelteinflüssen sind und den thermischen Belastungen durch Sonneneinstrahlungen und Abschattung widerstehen.

**Lösung**

Die Aufgabe wird durch die Gegenstände der Patentansprüche gelöst.

Es wurde überraschenderweise gefunden, dass sich ein Solarmodul mit ausreichender Tragfähigkeit, hoher thermischer Stabilität und geringem Gewicht bereitstellen lässt, wenn die Frontscheibe und die Rückscheibe unterschiedliche Dicken aufweisen.

Das erfindungsgemäße Solarmodul weist mindestens eine Frontscheibe und eine Rückscheibe auf, wobei eine der beiden Scheiben eine größere Dicke als die andere Scheibe aufweist, dabei weist die eine Scheibe eine Dicke von mindestens 3 mm $\pm$8% und die andere eine Dicke von höchstens 2 mm $\pm$ 8% auf. Bevorzugt weisen die beiden Scheiben unterschiedliche thermische Ausdehnungskoeffizienten auf.

Die erfindungsgemäßen Solarmodule weisen ferner eine Zwischenschicht auf. Die Zwischenschicht setzt sich bevorzugt aus Einbettungsmaterialschichten und Solarzellen zusammen. Die Einbettungsmaterialschichten können bevorzugt selbst Laminate sein, d.h. aus mehreren Einzelschichten bestehen. Die Einbettungsmaterialschichten umfassen bevorzugt EVA (Ethylen-Vinyl-Acetat). EVA ist preiswert und hat gut bekannte Eigenschaften. Die Einbettungsmaterialien sind bevorzugt Folien mit Dicken zwischen 0,4 und 0,8 mm.

Bei den Solarzellen handelt es sich bevorzugt um Scheiben aus polykristallinem Silizium mit Dicken zwischen 0,1 und 0,4 mm.

In einer alternativen Ausführungsform der vorliegenden Erfindung besteht die Zwischenschicht des Solarmoduls aus den Solarzellen, d.h. dass keine Einbettungsmaterialschichten zum Einsatz kommen. Dies geschieht in der Regel mit einer transparenten und elektrisch leitenden Zwischenschicht. In diesem Fall ist es erfindungsgemäß besonders bevorzugt, dass die Dicke der dünneren Scheibe wenigstens 0,7 mm und sicherheitshalber ganz besonders bevorzugt mehr als 0,9 mm beträgt, um die Solarzellen ausreichend vor Stoßlasten zu schützen.

Bei der Herstellung von Scheiben, insbesondere Glasscheiben, treten technisch bedingt Dickenschwankungen auf. Diese liegen erfahrungsgemäß im Bereich von ±8% um den Sollwert. Mit Dickenschwankung ist gemeint, dass mehrere Scheiben, die einen Sollwert für ihre Dicke gemeinsam haben, sich in ihrer Dicke, oder auch Stärke, unterscheiden. Die erfindungsgemäßen Solarmodule umfassen Scheiben, die bevorzugt nach einem Floatverfahren hergestellt sind.

Folglich sind auch solche Ausführungsformen von der vorliegenden Erfindung umfasst, bei denen die Dicke der jeweils dickeren Scheibe um ± 8% um den Soll-Wert schwankt. Bevorzugt betragen die Dickenschwankungen nur 7%, weiter bevorzugt 5%, mehr bevorzugt 4% und am meisten bevorzugt 3%.

Eine Dickenschwankung von 8% um den Sollwert führt dazu, dass bei einer beabsichtigten Dicke einer Charge von Frontscheiben mit einem Sollwert von 3 mm, die Dicke der erhaltenen Scheiben herstellungsbedingt zwischen 2,76 bis 3,24 mm misst.

Bevorzugt sind die Gläser, aus denen die verschiedenen Scheiben der erfindungsgemäßen Solarmodule hergestellt sind, ausgewählt aus der Gruppe bestehend aus Natronsilicatgläsern, Borsilicatgläsern und Lithiumaluminiumsilicatgläsern. Es ist dabei erfindungsgemäß bevorzugt, dass die dickere Scheibe aus Natronsilicatglas gefertigt wird. Dies ist bevorzugt besonders dann zutreffend, wenn die dickere Scheibe die Rückscheibe des Solarmoduls darstellt. Insbesondere die dickere Scheibe des Solarmoduls wird bevorzugt über das Floatverfahren hergestellt. Die dünnere Scheibe ist bevorzugt aus der Familie der Borsilicatgläser oder Lithiumaluminiumsilicatgläser gefertigt. Dies ist besonders bevorzugt dann zutreffend, wenn es sich bei der dünneren Scheibe um die Frontscheibe des Solarmoduls handelt. Diese dünnere Scheibe wird bevorzugt über das Walzverfahren hergestellt.

In einer besonderen bevorzugten Ausführungsform der vorliegenden Erfindung sind sowohl die Frontscheibe als auch die Rückscheibe aus Kalknatronsilicatglas gefertigt. In einer anderen bevorzugten Ausführungsform der Erfindung, sind sowohl Front- als auch Rückscheibe aus Borsilicatgläsern gefertigt.

Von den beiden Scheiben ist eine ausreichend dick, um dem Solarmodul einen wesentlichen Teil seiner Tragfähigkeit zu verleihen. Die andere Scheibe ist zwar dünn, kann aber dennoch die eingekapselten Solarzellen wirkungsvoll schützen und einen Beitrag zur Tragfähigkeit liefern. Bevorzugt beträgt die Dicke der dickeren Scheibe mehr als 3,5 mm, um ihre Tragfähigkeit zu erhöhen. Diese Ausführungsform wird besonders bevorzugt, wenn die längere Kante des Solarmoduls mehr als 1,5 m beträgt, was erfindungsgemäß bevorzugt ist.

Insbesondere bei Solarmodulen mit einer Länge der längeren Kante von - erfindungsgemäß weiter bevorzugt - mehr als 2 m, ist es vorteilhaft, eine Dicke der dickeren Scheibe von 4 mm oder mehr zu wählen, weil das die Verkürzung des Scheibenverbundes in der Modulebene durch Druck oder Sogbelastungen reduziert. Dadurch wird der erforderliche Einstand des Verbundes im Modulrahmen verringert und somit die photovoltaisch wirksame Fläche des Solarmoduls erhöht.

Sofern Module mit einer Länge der längeren Kante von weniger als 3 m eingesetzt werden, ist es nicht erforderlich, dass die dickere Scheibe eine Dicke von über 6 mm aufweist. Es ist erfindungsgemäß bevorzugt, dass in diesem Fall und sofern die dickere Scheibe thermisch vorgespannt ist, eine Dicke von unter 5 mm ausreicht. Diese Ausführungsform ist wegen ihrer Gewichtsersparnis bevorzugt.

Es ist erfindungsgemäß weiter bevorzugt, dass die dünnere Scheibe eine Dicke von weniger als 1,5 mm aufweist, sodass weiteres Gewicht eingespart werden kann. Sofern die Dicke der Zwischenschicht mehr als 0,8 mm beträgt, kann die Dicke der dünneren Scheibe bevorzugt weniger als 1,2 mm betragen. Diese noch leichtere Ausführungsform ist deshalb mehr bevorzugt. Die dünnere Scheibe ist bevorzugt wenigstens 0,3 mm dick, um die Solarzellen vor äußeren Einflüssen zu schützen. Bevorzugt hat die dünnere Scheibe eine Dicke von wenigstens 0,5 mm, um eine optimale Festigkeit gegen Stoß und Eindruck zu gewährleisten. Eine Dicke von mehr als 0,7 mm ist erfindungsgemäß bevorzugt, damit sich die Scheibe mit etablierten Vorrichtungen im Fertigungsprozess sicher handhaben lässt. Eine bevorzugt hohe Festigkeit lässt sich bei einer Dicke der dünneren Scheibe von mehr als 0,9 mm erreichen.

Es ist erfindungsgemäß bevorzugt, dass die dünnere Scheibe die Frontscheibe des Solarmoduls darstellt, da so leichter die erforderlichen optischen Transmissionen erreicht werden können. Ferner lassen sich dadurch die Kosten für z.B. besonders eisenarme Gemenge für hochtransparente Gläser vermindern.

Es ist bevorzugt, dass das erfindungsgemäße Solarmodul eine dickere Scheibe aufweist, die einen größeren linearen thermischen Ausdehnungskoeffizienten als die dünnere Scheibe hat. Es ist überraschenderweise so, dass die erfindungsgemäßen positiven Effekte weitgehend von den Eigenschaften der Einbettungsmaterialien unabhängig sind. Ferner kommt es für den erfindungsgemäßen Effekt nicht auf den konkreten Ausdehnungskoeffizienten der beteiligten Scheiben an, sondern auf die Differenz der Ausdehnungskoeffizienten.

Es ist daher bevorzugt, dass der thermische Ausdehnungskoeffizient der dickeren Scheibe wenigstens $3 \cdot 10^{-6}$ $K^{-1}$ höher ist als der der dünneren Scheibe, weil dann auch bei Temperaturschocks des ganzen Verbundes (z.B. bei einem Platzregen) die thermische Vorwölbung ("Bimetalleffekt") des Verbundes klein ist. In einer weiter bevorzugten Ausführungsform ist der Ausdehnungskoeffizient der dickeren Scheibe um wenigstens $4 \cdot 10^{-6}$ $K^{-1}$ höher als der der dünneren Scheibe, weil dass die Widerstandsfähigkeit des Verbundes bei vertikalen Temperaturgradienten weiter verbessert. Ist der Ausdehnungskoeffizient der dickeren Scheibe um mehr als $4,5 \cdot 10^{-6}$ $K^{-1}$ höher als der der dünneren Scheibe, wird sogar eine Verbesserung der Widerstandsfähigkeit des Verbundes gegenüber horizontalen Temperaturgradienten durch Schlagschatten beobachtet. Folglich ist diese Ausführungsform stärker bevorzugt.

Gerade bei dünnen Scheiben tritt das Problem auf, dass sie sich nur schlecht oder gar nicht (bei Dicken unter 1,2 mm) thermisch vorspannen lassen und chemisches Vorspannen aus Kostengründen nicht in Frage kommt. Eine spezielle Ausführungsform der vorliegenden Erfindung schafft hier Abhilfe.

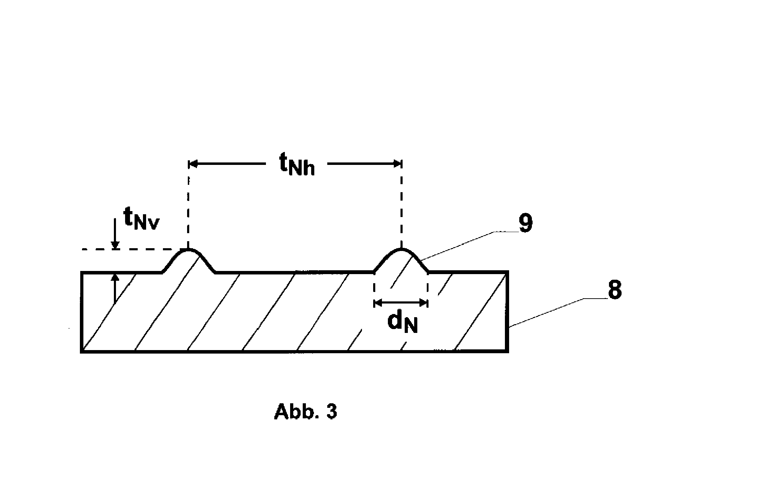

In einer erfindungsgemäßen bevorzugten Ausführungsform weisen die Oberflächen des Solarmoduls eine Noppung auf, d.h. auf der Oberfläche werden z.B. durch Einwalzen am Glaszug in möglichst regelmäßiger Anordnung kegelförmige Erhebungen mit stumpfer Spitze eingebracht. Abbildung 3 zeigt das Prinzip der Noppung. In einer Scheibe, die entweder die Frontscheibe oder die Rückscheibe darstellen kann, sind auf wenigstens einer Fläche Noppen mit möglichst gleichmäßiger Höhe $t_{Nv}$, Durchmesser der Basis $d_N$ und Abstand $t_{Nh}$ eingebracht.

Es ist erfindungsgemäß bevorzugt, dass die Noppenhöhe $t_{Nv}$ wenigstens 0,03 mm beträgt, um den festigkeitssteigernden Effekt zu erreichen. Die Noppenhöhe beträgt bevorzugt wenigstens 0,10 mm, damit die Noppen in einer abrasiven Umgebung (z.B. bei Lagerung, Handling, Einsatz) nicht zu leicht abgeschliffen werden können. Die Höhe der Noppen soll bevorzugt jedoch weniger als 0,5 mm betragen, um ihren Ausbrechwiderstand zu erhöhen und die stumpfe Form der Noppenspitze einfacher zu erreichen. Bevorzugt beträgt die Noppenhöhe mehr als 0,12 mm und weniger als 0,22 mm, damit sie bei der Fertigung der Scheiben mit ausreichender Prozessstabilität in die Glasoberfläche mit eingewalzt werden können. Außerdem lassen sich in Glasscheiben mit einer Dicke von weniger als 1,5 mm Noppen mit einer Höhe von mehr als 0,2 mm nur mit großem Aufwand einwalzen oder einpressen.

Die Noppen können z.B. in Rechteck- oder Hexagonalanordnung vorliegen. Die Hexagonalanordnung wird bevorzugt, so dass die Glasoberfläche in den Noppenzwischenräumen nicht durchgängig verkratzt werden kann.

Statt des Noppenabstandes ist es sinnvoller, von der Noppendichte $\Sigma_N$ (Anzahl der Noppen pro Flächeneinheit) zu sprechen. Die Noppendichte $\Sigma_N$ soll wenigstens 4 $cm^{-2}$ betragen, damit der festigkeitssteigernde Effekt auftritt. Bevorzugt beträgt die Noppendichte mehr als 10 $cm^{-2}$, weil dass die Wahrscheinlichkeit eines Verkratzens der Scheibenoberfläche in den Noppenzwischenräumen weiter vermindert.

Es ist erfindungsgemäß bevorzugt, dass die dünnere Scheibe durch Noppung in ihrer Festigkeit gesteigert wird. Die genoppte Scheibe ist bevorzugt auf der Außenseite genoppt. Es ist besonders bevorzugt, dass die genoppte Scheibe beidseitig genoppt ist, weil dass die Stoßfestigkeit der Scheibe verbessert.

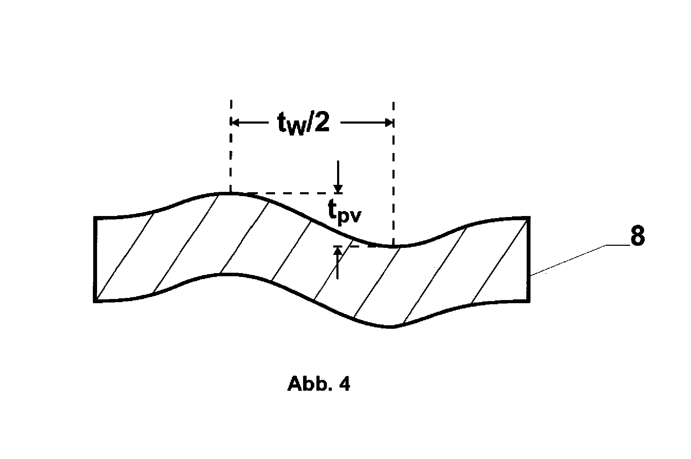

Eine weitere spezielle Ausführungsform der vorliegenden Erfindung ist die Wölbstrukturierung der Scheiben. Dabei werden die Glasscheiben als ganzes z. B. mittels geformter Walzenpaare am Glaszug verformt. Abbildung 4 zeigt das Prinzip. Eine Scheibe, die entweder Frontscheibe oder Rückscheibe darstellen kann, weist wellenförmige Erhebungen und Absenkungen mit einer Pfeilhöhe $t_{pv}$ (auf einer Seite der Scheibe gemessener Unterschied von der höchsten zur tiefsten Position bzw. vom Wellenberg zum Wellental) und Wellenlänge $t_W$ auf. Die Dicke der Scheibe bleibt dabei im Wesentlichen gleich.

Die Pfeilhöhe $t_W$ sollte wenigstens 0,3 mm betragen damit der festigkeitssteigernde Effekt auftritt. Bevorzugt beträgt die Pfeilhöhe mindestens 1 mm, weil das zu einer gewünschten Versteifung der Scheibe führt. Die Pfeilhöhe soll vorzugsweise weniger als 1 cm betragen, weil das Solarmodul sonst zu dick würde. Bevorzugt beträgt die Pfeilhöhe weniger als 3 mm, um die Menge des erforderlichen Einbettungsmaterials zu begrenzen.

Die Wölbstrukturierung kann z.B. Rechteck- oder Hexagonalstruktur aufweisen. Die Hexagonalstruktur wird bevorzugt, weil das die Biegesteifigkeit der Scheibe erhöht. Es ist erfindungsgemäß bevorzugt, dass für die Wölbstrukturierung gilt, das $t_W \geq 12\, t_{pv}$ ist. Wird dieses Verhältnis eingehalten, werden die Flanken der Wellen so flach, dass bei einer Kontakt- oder Stoßlast der Impaktor i.d.R. ohne Beschädigung der Glasoberfläche abgleitet.

Die Wölbstrukturierung ist vor allem nützlich zur Steigerung der Festigkeit der dünneren Scheibe. Erfindungsgemäß wird bei wölbstrukturierten Glasscheiben als Scheibendicke die definierte mittlere Dicke verwendet, die folgendermaßen definiert ist:

$$\bar{t} = \sqrt[3]{t^3 + 0,15 \cdot z^3} \qquad \text{mit} \qquad z = \min(t, t_{pv})$$

t bezeichnet dabei die Nenndicke der Scheibe, d.h. die an einer geeigneten Stelle im mittleren Bereich der Scheibe gemessene Dicke und $t_{pv}$ die Pfeilhöhe der Wölbstrukturierung.

In einer besonders bevorzugten erfindungsgemäßen Ausführungsform ist die wölbstrukturierte Scheibe zusätzlich genoppt. Bei wölbstrukturierten und genoppten Glasscheiben wird als Scheibendicke die Auslegung des Solarmoduls die definierte mittlere Dicke verwendet, die folgendermaßen definiert ist:

$$\ddot{\bar{t}} = \sqrt[3]{\bar{t}^3 + 0,15 \cdot z^3} \qquad \text{mit} \qquad z = \min(\bar{t}, t_{pv})$$

t bezeichnet dabei die aus der Oberflächenstrukturierung resultierende mittlere Scheibendicke.

**Beispiel 1:** Bei einem quadratischen Solarmodul mit der Kantenlänge von 2 m besteht die Frontscheibe aus Kalk-Natron-Silikat-Glas mit einem Ausdehnungskoeffizienten von $8,5 \cdot 10^{-6}$ 1/K. Die Dicke der Frontscheibe beträgt 0,9 mm. Die Summe der Dicken der Zwischenlagen mit den Zellen beträgt 1,3 mm. Die Rückscheibe besteht ebenfalls aus Kalk-Natron-Silikat-Glas mit einem Ausdehnungskoeffizienten von $8,5 \cdot 10^{-6}$ 1/K und ist thermisch vorgespannt mit einer Biegefestigkeit von wenigstens 90 MPa. Ihre Dicke wird zu 4,5 mm gewählt.

**Beispiel 2:** Bei einem rechteckigen Solarmodul mit der Kantenlänge von 2,5 m und 1,5 m besteht die Frontscheibe aus Bor-Silikat-Glas mit einem Ausdehnungskoeffizienten von $4,5 \cdot 10^{-6}$ 1/K. Die Dicke der Frontscheibe beträgt 0.7 mm. Zur Verbesserung der Stoßfestigkeit sind in die Frontscheibe beidseitig Noppen in hexagonaler Anordnung mit einer Höhe von 0,15 mm und einer Dichte von 20 $cm^{-2}$ eingewalzt. Die Summe der Dicken der Zwischenlagen mit den Zellen beträgt 1,4 mm. Die Rückscheibe ebenfalls aus Bor-Silikat-Glas mit einem Ausdehnungskoeffizienten von $4,5 \cdot 10^{-6}$ 1/K ist thermisch vorgespannt mit einer Biegefestigkeit von wenigstens 90 MPa und hat eine Dicke von 5 mm.

**Beispiel 3:** Bei einem quadratischen Solarmodul mit der Kantenlänge von 2 m besteht die Frontscheibe aus Kalk-Natron-Silikat-Glas mit einem Ausdehnungskoeffizienten von $8,5 \cdot 10^{-6}$ 1/K. Die Dicke der Frontscheibe beträgt 0,9 mm. Die Summe der Dicken der Zwischenlagen mit den Zellen beträgt 1,3 mm. Die Rückscheibe besteht aus Kalk-Natron-Silikat-Glas mit einem Ausdehnungskoeffizienten von $8,5 \cdot 10^{-6}$ 1/K und ist zur Verbesserung der Biegesteifigkeit in hexagonaler Anordnung durch Schwerkraftsenken wölbstrukturiert mit einer Pfeilhöhe von 1 mm und einer Hügeldichte von 5 $cm^{-2}$. Die Rückscheibe ist thermisch vorgespannt mit einer Biegefestigkeit von wenigstens 90 MPa und hat eine Dicke von 4 mm.

**Beispiel 4:** Bei einem rechteckigen Solarmodul mit der Kantenlänge von 2,5 m und 1,5 m besteht die Frontscheibe aus Bor-Silikat-Glas mit einem Ausdehnungskoeffizienten von $4,5 \cdot 10^{-6}$ 1/K und einer Dicke von 0,7 mm. Zur Verbesserung der Stoßfestigkeit sind in die Frontscheibe beidseitig Noppen in hexagonaler Anordnung mit einer Höhe von 0,15 mm und einer Dichte von 20 $cm^{-2}$ eingewalzt. Die Summe der Dicken der Zwischenlagen mit den Zellen beträgt 1.4 mm. Die Rückscheibe aus Kalk-Natron-Silikat-Glas mit einem Ausdehnungskoeffizienten von $8,5 \cdot 10^{-6}$ 1/K ist zur Erhöhung der Biegesteifigkeit in hexagonaler Anordnung wölbstrukturiert mit einer Pfeilhöhe von 1 mm und einer Hügeldichte von 4 $cm^{-2}$. Die Rückscheibe ist thermisch vorgespannt, so dass eine Biegefestigkeit von wenigstens 90 MPa erreicht wird. Ihre Dicke beträgt 4 mm.

**Beschreibung der Abbildungen**

Die Abbildungen 1 und 2 zeigen übliche Ausgestaltungen von Solarmodulen, die Abbildungen 3 und 4 zeigen erfindungsgemäße Solarmodule; die Abbildung dienen der Illustration und schränken den Erfindungsgegenstand nicht ein.

**Abb. 1**

Solarmodule des Standes der Technik haben üblicherweise einen Aufbau gemäß Abbildung 1. Demnach umfassen Solarmodule üblicherweise eine Frontscheibe 2, eine Rückscheibe 3 und eine Zwischenschicht 4.

**Abb. 2**

Diese Abbildung zeigt ein Solarmodul mit den bevorzugt vorhandenen Zwischenschichten. Die Zwischenschicht setzt sich wie in Abbildung 2 gezeigt meist aus Einbettungsmaterialschichten 5 und 6 sowie den Solarzellen 7 zusammen. Die Einbettungsmaterialschichten 5 und 6 können selbst Laminate sein, also aus mehreren Einzelschichten bestehen.

**Abb. 3**

Abbildung 3 zeigt das Prinzip der Noppung. In einer Scheibe 8, die entweder die Frontscheibe oder die Rückscheibe darstellen kann, sind auf wenigstens einer Fläche Noppen 9 mit möglichst gleichmäßiger Höhe $t_{Nv}$, Durchmesser der Basis $d_N$ und Abstand $t_{Nh}$ eingebracht.

**Abb. 4**

Abbildung 4 zeigt das Prinzip. Eine Scheibe 8, die entweder Frontscheibe oder Rückscheibe darstellen kann, weist wellenförmige Erhebungen und Absenkungen mit einer Pfeilhöhe $t_{pv}$ (auf einer Seite der Scheibe gemessener Unterschied von der höchsten zur tiefsten Position) und Wellenlänge $t_W$ auf. Die Dicke der Scheibe bleibt dabei im Wesentlichen gleich.

**Bezugzeichenliste**

1 Solarmodul
2 Frontscheibe
3 Rückscheibe
4 Zwischenschicht
5 Einbettungsmaterialschicht
6 Einbettungsmaterialschicht
7 Solarzellen
8 Scheibe
9 Noppen

**Patentansprüche**

1. Solarmodul (1) mit einer Frontscheibe (2) und einer Rückscheibe (3), wobei eine der beiden Scheiben eine Dicke von mindestens 3 mm $\pm$8% und die andere eine Dicke von höchstens 2 mm $\pm$8% aufweist.

2. Das Solarmodul (1) nach Anspruch 1, wobei die dünnere Scheibe eine Dicke von mindestens 0,3 mm $\pm$8% aufweist.

3. Das Solarmodul (1) nach Anspruch 1 oder 2, wobei die Frontscheibe (2) die dünnere Scheibe ist.

4. Das Solarmodul (1) nach einem oder mehreren der vorhergehenden Ansprüche, wobei die dickere Scheibe einen höheren thermischen Ausdehnungskoeffizienten hat als die dünnere Scheibe.

5. Das Solarmodul (1) nach einem oder mehreren der vorhergehenden Ansprüche, wobei die dickere Scheibe einen um wenigstens $3*10^{-6}$ $K^{-1}$ höheren thermischen Ausdehnungskoeffizienten hat als die dünnere Scheibe.

6. Das Solarmodul (1) nach einem oder mehreren der vorhergehenden Ansprüche, wobei wenigstens eine der beiden Scheiben auf wenigstens einer Seite eine Noppung (9) aufweist.

7. Das Solarmodul (1) nach Anspruch 6, wobei die Noppenhöhe wenigstens 0,03 mm beträgt.

8. Das Solarmodul (1) nach Anspruch 6 oder 7, wobei die Noppenhöhe höchstens 0,5 mm beträgt.

9. Das Solarmodul (1) nach einem oder mehreren der Ansprüche 6 bis 8, wobei die Noppen (9) in Hexagonalanordnung aufgebracht sind.

10. Das Solarmodul (1) nach einem oder mehreren der Ansprüche 6 bis 9, wobei die Noppendichte mindestens 4 $cm^{-2}$ beträgt.

**11.** Das Solarmodul (1) nach einem oder mehreren der vorhergehenden Ansprüche, wobei wenigstens eine der beiden Scheiben eine Wölbstruktur aufweist.

**12.** Das Solarmodul (1) nach Anspruch 11, wobei eine Pfeilhöhe $t_{pv}$ wenigstens 0,3 mm beträgt.

**13.** Das Solarmodul (1) nach einem oder mehreren der vorhergehenden Ansprüche, wobei die dickere Scheibe aus Natronsilicatglas gefertigt ist.

**14.** Das Solarmodul (1) nach einem oder mehreren der vorhergehenden Ansprüche, wobei die dünnere Scheibe aus Borsilicatglas oder Lithiumaluminiumsilicatglas gefertigt ist.

Abb. 1

Abb. 2

EP 2 239 784 A2

Abb. 3

Abb. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1798775 A2
- DE 102005057468 A1
- DE 102005030039 A1